# EUROPÄISCHE PATENTANMELDUNG

(11) **EP 1 484 430 A2**
(43) Veröffentlichungstag der Anmeldung: **08.12.2004**
(21) Anmeldenummer: 04010892.0
(22) Anmeldetag: 07.05.2004
(51) Int. Cl.: C23C 18/08

(54) **Abscheidung von Kupferschichten auf Substraten**

(30) Priorität: 03.06.2003 DE 10325243
(71) Anmelder: BASF AKTIENGESELLSCHAFT, 67056 Ludwigshafen (DE)
(72) Erfinder: Sterzel, Hans-Josef, Dr., 67125 Dannstadt-Schauernheim (DE); Wittenbecher, Lars, Dr., 68159 Mannheim (DE); Deck, Patrick, Dr., 68165 Mannheim (DE)

(57) **Zusammenfassung**

Verfahren zur Abscheidung von Kupferschichten auf Substraten, indem man das Substrat mit einer Lösung von Kupfer-II-formiat und Alkoxyalkylaminen der allgemeinen Formel I R¹-O-(CH₂)ₙ=CHR²-NH₂, in der R¹ Methyl oder Ethyl und R² Wasserstoff oder Methyl bedeutet und n für 1, 2, 3 oder 4 steht, bei Temperaturen von 120 bis 200°C und einem Druck von 0,1 bis 5 bar in Kontakt bringt.

## Beschreibung

Die Erfindung betrifft die Abscheidung von Kupferschichten auf Substraten.

Aus der Copper-Fundamentals, Mechanisms for Microelectronic Applications, John Wiley & Sons 2000, Seite 301-302, paragraph 9.5.3 ist die stromlose Abscheidung von metallischem Kupfer aus wässrigen Cu²⁺-Bädern mit Formaldehyd als Reduktionsmittel bekannt. Derartige Bäder enthalten üblicherweise noch eine Reihe von Hilfsmitteln wie Komplexbildner, Inhibitoren, evtl. Verlaufmittel. Hierbei ist es erforderlich, vor der eigentlichen Abscheidung eine Keimbildung über Platinmetalle durchzuführen, die über ein anderes Bad appliziert werden.

Aus der WO-A-97/33713 ist weiterhin das Aufbringen von metallischem Kupfer durch Einsatz von Dispersionen, die Metallpartikel mit Teilchengrößen von 10 bis 100 nm enthalten, bekannt. Derartige Dispersionen, auch Tinten genannt, enthalten zusätzlich noch Dispergiermittel wie Polyvinylpyrrolidon, längerkettige Alkohole, Amine oder Säureamide. Nachteilig an diesem Verfahren ist, daß die Dispergiermittel notwendigerweise höher- bis hochmolekular sind und in die Metallschicht eingebaut werden, wodurch die Qualität der Schicht beeinträchtigt wird. Auf jeden Fall müssen die Dispergiermittel nach der Schichtausbildung aufwendig entfernt werden.

Der vorliegenden Erfindung lag daher die Aufgabe zugrunde, den zuvor genannten Nachteilen abzuhelfen.

Demgemäß wurde ein neues und verbessertes Verfahren zur Abscheidung von Kupferschichten auf Substraten gefunden, welches dadurch gekennzeichnet ist, daß man das Substrat mit einer Verbindung aus Kupfer-II-formiat und Alkoxyalkylaminen der allgemeinen Formel I R¹-O-(CH₂)ₙ CHR²-NH₂, in der R¹ Methyl oder Ethyl und R² Wasserstoff oder Methyl bedeutet und n für 1, 2, 3 oder 4 steht, bei Temperaturen von 80 bis 200°C und einem Druck von 0,1 bis 5 bar in Kontakt bringt.

Das erfindungsgemäße Verfahren kann wie folgt durchgeführt werden:

Die Verbindung aus Kupfer-II-formiat und Alkoxyalkylaminen der allgemeinen Formel I R¹-O-(CH₂)ₙ-CHR ²-NH₂, in der R¹ Methyl oder Ethyl und R² Wasserstoff oder Methyl bedeutet und n für 1, 2, 3 oder 4 steht, und gegebenenfalls einem inerten Lösungsmittel kann bei Temperaturen von 80 bis 200°C, bevorzugt 80 bis 150°C, besonders bevorzugt 100 bis 150°C und einem Druck von 0,1 bis 5 bar, bevorzugt 0,5 bis 2 bar, besonders bevorzugt Normaldruck (Atmosphärendruck) mit dem Substrat in Kontakt gebracht werden.

Die Kontaktierung des Substrates mit der Verbindung aus Kupfer-II-formiat und Alkoxyalkylaminen I und gegebenenfalls einem inerten Lösungsmittel kann mit allen bekannten Applikationstechniken wie beispielsweise Tauchen, Sprühen, Sprühtrocknen, Aufdrucken, Spin-Coating, Infiltrieren, Aufmalen, Aufschreiben oder Drucken durchgeführt werden. Dabei ist das Substrat in der Regel vorgeheizt oder es kann jedoch auch kalt eingesetzt werden und man erhitzt die ausgerüsteten Substrate anschließend.

Die Verbindungen aus Kupfer-II-formiat und Alkoxyalkylaminen I können als Reaktionsverbindungen, Komplexe oder als gelöste Gemische vorliegen.

Flächig zu beschichtende Substrate können beispielsweise durch Drucktechniken wie Siebdruck, Hochdruck, Tiefdruck, Offsetdruck, Tampondruck oder Inkjetdruck infiltriertwerden.

Steife, flächige Substrate, insbesondere Wafer für die Mikroelektronik, können über Spin-Coating beschichtet und anschließend erhitzt werden.

Beispielsweise in heizbaren Mischtrommeln lassen sich unter Drehung Schüttgut, Bruchgut und Mahlgut (Z.B. Pulver) beschichten. In einer bevorzugten Ausführung werden Sprühtrockner verwendet.

Die so erhaltenen Pulver eignen sich zur Herstellung elektrisch leitfähiger Klebebänder oder beispielsweise zur Füllung von Kunststoffen, um diese antistatisch auszurüsten, elektrisch leitend und/oder undurchlässig für elektromagnetische Strahlung zu machen.

Durch das erfindungsgemäße Verfahren ist es beispielsweise möglich, gedruckte Schaltungen in einem Schritt unter Einsparung fotolithografischer Verfahren herzustellen, poröse Substrate in Tantal- oder keramischen Kondensatoren in einem einzigen Schritt ohne Waschschritte mit Kupferschichten zu beschichten, optisch aktive Elemente hochauflösender Displays in besonders vorteilhafter Weise zu kontaktieren, flexible Verbindungen zwischen Mikrochips, Batterien und sonstigen Bauteilen auf flexiblen Folien bereitzustellen, die in geeigneten geometrischen Formen auch als Sende- und Empfangsantennen für die elektronischen Schaltungen verwendbar sind.

Erfindungsgemäß hergestellte leitfähige poröse Materialien mit spezifischen Oberflächen von 0,01 bis 10 m²/g lassen sich beispielsweise vorteilhaft als Elektroden in Elektrolysezellen oder Batterien einsetzen.

Schließlich ist es auch möglich, die Verbindungen aus Kupfer-II-formiat und Alkoxyalkylaminen I und einem inerten Lösungsmittel direkt zu sehr feinteiligem Kupferpulver zu verarbeiten. Vorteilhafter Weise werden zu diesem Zweck niedrigviskos eingestellte Lösungen der Kupferkomplexe in einem Sprühtrockner versprüht, wobei die Flüssigkeitszuführung unterhalb der Zersetzungstemperatur (unterhalb von ca. 90°C) gehalten wird, das inerte Trocknungsgas, beispielsweise Stickstoff, 10 bis 100°C oberhalb der Zersetzungstemperatur. Es lassen sich so Kupferpulver frei von Verunreinigungen herstellen, die Teilchengrößen bis hinunter zu 1 nm aufweisen. Zur Verhinderung der Agglomeration derart kleiner Kupferpulver werden diese vorteilhaft direkt in einer geeigneten Flüssigkeit wie Aminen, Alkoholen, Ketonen, Kohlenwasserstoffen oder deren Gemischen aufgefangen.

Die Herstellung der Verbindungen aus Kupfer-II-formiat und Alkoxyalkylaminen I und gegebenenfalls einem inerten Lösungsmittel kann dadurch erfolgen, dass man unter Inertgasatmosphäre z.B. Stickstoff oder Argon, im wesentlichen frei von CO₂, Alkoxyalkylamin I oder deren Gemische vorlegt und Kupfer-II-formiat, beispielsweise als 4-Hydrat, einträgt. Dabei sollte die Temperatur in der Regel 60 bis 70°C nicht übersteigen.

Indem man die stöchiometrisch notwendigen 2 Mole Alkoxyalkylamin I pro Mol Kupfer-II-formiat vorlegt erhält man die größtmögliche Kupferkonzentration und gleichzeitig eine oft erwünschte hohe Produktviskosität.

Sind für die Verarbeitung niedrigere Viskositäten erwünscht, so setzt man inerte Lösungsmittel, beispielsweise Ketone wie Aceton, Methylethylketon oder Aromaten wie Toluol oder Xylole zu, oder man setzt eine überstöchiometrische Menge Alkoxyalkylamin I ein.

Ist für besondere Anwendung die durch das Kristallwasser des Kupfer-II-formiats eingeführte Wassermenge störend, so kann man ebenfalls einen Überschuss, in der Regel von 0,5 bis 5 Mol, bevorzugt 0,5 bis 2 Mol an Alkoxyalkylamin I einsetzen und unter vermindertem Druck bei maximal 60 bis 70°C das überschüssige Amin gleichzeitig mit dem Wasser entfernen, z.B. abdestillieren.

Um die Haftung und die Homogenität des Kupfers auf den zu beschichtenden Oberflächen zu verbessern, ist es ggf. vorteilhaft, Additive in geringen Mengen von 0,01 bis 0,5 Gew.-%, bevorzugt 0,02 bis 0,1 Gew.-% den Verbindungen aus Kupfer-II-formiat und Alkoxyalkylaminen I zuzumischen. Als Additive eignen sich beispielsweise kommerziell erhältliche Verlaufsmittel wie Polysiloxane, deren Endgruppen durch Polyetherblöcke umschlossen sind, z.B. TEGO® Glide 432 der Firma Degussa.

Als Substrate eignen sich in der Regel alle Materialien, sowohl elektrisch leitfähige als auch elektrisch schlecht oder nicht leitfähige Materialien mit glatter oder poröser Struktur und Oberfläche, beispielsweise Kunststoffe, bevorzugt wärmebeständige Polymere wie Polybutylenterephthalat, Polyamid-6, Polyamid-6,6, Polycarbonat, Polysulfon, Polyethersulfon, Polyphenylensulfid; Glas, Oxide, Metalle oder Keramik. Die Form dieser Substrate ist in der Regel beliebig, beispielsweise Platten, Folien, Schäume, Kugeln, Hohlkugeln, Formkörper in Form von Sternen, Wagenrädern, Zylinder, Quader, Rechtecke, Kegel, Waben sowie Schüttgut, Bruchgut und Mahlgut.

Als Alkoxyalkylamine eignen sich solche der allgemeinen Formel I R¹-O-(CH₂)ₙ CHR²-NH₂, in der R¹ Methyl oder Ethyl, R² Wasserstoff oder Methyl bedeutet und n für 1, 2, 3 oder 4 steht. Bevorzugt sind Alkoxyalkylamine I mit Siedepunkten unter Normaldruck (Atmosphärendruck) von 80 bis 150°C, besonders bevorzugt CH₃-O-CH₂-CH₂-NH₂, CH₃-O-CH₂-CH(CH₃)-NH₂, CH₃-O-(CH₂)₂-CH₂-NH₂ und C₂H₅-O-(CH₂)₂-CH₂-NH₂.

### Beispiele

### Beispiel 1

### Umsetzung von Kupfer(II)-formiat mit 2-Methoxyethylamin

Unter einer Argonatmosphäre wurden 7,67 g (0,05 mol) Kupfer(II)-formiat Tetrahydrat (Cu(HCOO)₂* 4 H₂O) in 15 g (0,2 mol) 2-Methoxyethylamin bei einer Temperatur von bis zu 50°C eingetragen, 20 Min. gerührt und anschließend das überschüssige Amin und das Kristallwasser i.Vak. bei bis zu 60°C entfernt. Die resultierende Verbindung hatte einen Kupfergehalt von ca. 22 Gew.-%.

### Beispiel 2

### Umsetzung von Kupfer(II)-formiat mit 3-Methoxypropylamin

Die Umsetzung erfolgte analog Beispiel 1 jedoch wurde anstatt 2-Methoxyethylamin 17,82 g (0,2 mol) 3-Methoxypropylamin eingesetzt. Die resultierende Verbindung hatte einen Kupfergehalt von ca. 20 Gew.-%.

Zur weiteren Verarbeitung wurden der Verbindung 0,05 Gew.-% des Additivs (eines Verlaufsmittels) TEGO® Glide 432 zugesetzt.

### Beispiel 3

### Umsetzung von Kupfer(II)-formiat mit 3-Ethoxypropylamin

Die Umsetzung erfolgte analog Beispiel 1 jedoch wurde anstatt 2-Methoxyethylamin 20,64 g (0,2 mol) 3-Ethoxypropylamin eingesetzt. Die resultierende Verbindung hatte einen Kupfergehalt von ca. 17 Gew.-%.

### Beispiel 4

Gemisch aus 2-Methoxyethylamin und 3-Methoxypropylamin Die Umsetzung erfolgte analog Beispiel 1 jedoch wurde ein Gemisch aus 7,51 g (0,1 mol) 2-Methoxyethylamin und 8,91 g (0,1 mol) 3-Methoxypropylamin eingesetzt.

### Beispiel 5

### Abscheidung von Kupfer auf einer Glasoberfläche

2 ml der in Beispiel 2 hergestellten Verbindung wurde auf einen Objektträger aus Glas aufgebracht, verteilt und dieser unter Argonatmosphäre innerhalbvon 1 h auf eine Endtemperatur von ca. 180°C hochgeheizt. Die Endtemperatur wurde ca. 10 Minuten lang gehalten und daraufhin wieder bis auf Raumtemperatur abgekühlt.

Man erhielt eine gut haftende, gleichmäßige Kupferschicht, die den elektrischen Strom gut leitete.

### Beispiel 6

### Abscheidung von Kupfer auf den Polymerfolien

Die Abscheidung erfolgte analog Beispiel 5 auf den folgenden Polymerfolien: sulfoniertes Polyetheretherketon, (PEEK), Polybutylenterephthalat, Polyamid-6, Polyamid-6,6 und Polyethersulfon-Folie. Man erhielt gleichmäßige und gut leitende Schichten, die gut hafteten.

### Beispiel 7

### Abscheidung auf Hohlglaskugeln

10 g Hohlglaskugeln (Durchmesser 10 bis 30 µm) wurden unter Argonatmosphäre mit 4,5 g der in Beispiel 2 hergestellten Mischung vermischt und bei 180°C und 400 mbar getrocknet. Es entstanden nicht mit Kupfer überzogene Hohlglaskugeln, die den elektrischen Strom gut leiteten.

## Patentansprüche

1. Verfahren zur Abscheidung von Kupferschichten auf Substraten, **dadurch gekennzeichnet, daß** man das Substrat mit einer Verbindung aus Kupfer-II-formiat und Alkoxyalkylaminen der allgemeinen Formel I R¹-O-(CH₂)ₙ CHR²-NH₂, in der R¹ Methyl oder Ethyl und R² Wasserstoff oder Methyl bedeutet und n für 1, 2, 3 oder 4 steht, bei Temperaturen von 80 bis 200°C und einem Druck von 0,1 bis 5 bar in Kontakt bringt.

2. Verwendung von Verbindungen enthaltend Kupfer-II-formiat und Alkoxyalkylaminen der allgemeinen Formel I R¹-O-(CH₂)ₙ CHR²-NH₂, in der R¹ Methyl oder Ethyl und R² Wasserstoff oder Methyl bedeutet und n für 1, 2, 3 oder 4 steht, zur Beschichtung von Substraten.

3. Verwendung von Verbindungen bestehend aus Kupfer-II-formiat und Alkoxyalkylaminen der allgemeinen Formel I R¹-O-(CH₂)ₙ CHR²-NH₂, in der R¹ Methyl oder Ethyl und R² Wasserstoff oder Methyl bedeutet und n für 1, 2, 3 oder 4 steht, und gegebenenfalls einem inerten Lösungsmittel zur Beschichtung von Substraten.

4. Mischungen enthaltend Verbindungen aus Kupfer-II-formiat und Alkoxyalkylaminen der allgemeinen Formel I R¹-O-(CH₂)ₙ CHR²-NH₂, in der R¹ Methyl oder E-thyl und R² Wasserstoff oder Methyl bedeutet und n für 1, 2, 3 oder 4 steht, zur Beschichtung von Substraten.

5. Mischungen bestehend aus Verbindungen von Kupfer-II-formiat und Alkoxyalkylaminen der allgemeinen Formel I R¹-O-(CH₂)ₙ CHR²-NH₂, in der R¹ Methyl oder Ethyl und R² Wasserstoff oder Methyl bedeutet und n für 1, 2, 3 oder 4 steht, und gegebenenfalls einem inerten Lösungsmittel zur Beschichtung von Substraten.

6. Verbindungen aus Kupfer-II-formiat und Alkoxyalkylaminen nach einem der Ansprüche 1, 2, 3, 4 oder 5, **dadurch gekennzeichnet, dass** diese 0,01 bis 0,5 Gew.-% Additive enthalten.

7. Verfahren zur Herstellung von feinteiligem Kupfer, **dadurch gekennzeichnet, daß** man Verbindungen aus Kupfer-II-formiat und Alkoxyalkylaminen der allgemeinen Formel I R¹-O-(CH₂)ₙCHR²-NH₂, in der R¹ Methyl oder Ethyl und R² Wasserstoff oder Methyl bedeutet und n für 1, 2, 3 oder 4 steht, in einem inerten Lösungsmittel bei Temperaturen von 80 bis 200°C und einem Druck von 0,1 bis 5 bar sprühtrocknet.
